# EUROPEAN PATENT SPECIFICATION

(11) **EP 3 700 089 B1**
(45) Date of publication and mention of the grant of the patent: **01.01.2025**
(21) Application number: 19209015.7
(22) Date of filing: 14.11.2019
(51) Int. Cl.: H03K 17/96, B60K 35/10

(54) **TOUCH-TYPE BUTTON FOR VEHICLE**
TASTSCHALTER FÜR EIN FAHRZEUG
BOUTON DE TYPE TACTILE POUR VÉHICULE

(30) Priority: 25.02.2019 KR 20190021902
(43) Date of publication of application: 26.08.2020
(73) Proprietor: Hyundai Motor Company, Seoul 06797 (KR); Kia Corporation, Seocho-gu Seoul 06797 (KR)
(72) Inventor: KWEON, Kyoung-Chun, Seoul 06112 (KR)
(74) Representative: Isarpatent

(56) References cited:
- EP-A1- 2 960 916
- EP-A1- 3 219 534
- EP-B1- 3 251 213
- WO-A1-2018/002272
- JP-A- 2008 053 050
- US-A1- 2013 027 953
- US-A1- 2016 101 548
- US-A1- 2019 380 683

## Description

### TECHNICAL FIELD

The present disclosure relates to a touch-type button for operating an electronic device, an air conditioning device or the like of a vehicle.

### BACKGROUND

A vehicle is provided with buttons for operating an electronic device, such as an audio, video, navigation (AVN) device and the like, or an air conditioning device, an illuminating device including a light emitting diode (LED), and the like, the buttons having different characters thereon through which a user can know functions of the buttons.

A conventional mechanical button is configured such that light emitted from the LED is transmitted through an empty space of a button holding frame to allow the light to penetrate a surface of the button. When a user pushes such a button employing a push-pull type mechanical contact, electricity flows to allow a switch to be operated.

The button is configured such that the light emitting from the LED can penetrate the button which is generally formed from light-transmitting plastic material (mainly, polycarbonate (PC)) and has transmissivity (5 to 18%) for visible light.

In addition, instead of the above-described mechanical type button, an electrode for a touch-type button is used, which is made of a conductive material. When a human's hand approaches thereto, the touch-type button detects a change in signal relative to initial capacitance to recognize whether the button is turned on or off. The touch-type button has an advantage in that material having a high electric conductivity can produce larger capacitance.

In recent years, a transparent electrode has been precisely manufactured through a deposition process or the like in order to provide a high-definition display device with a touch function.

Silver (Ag) nanowire, silver metal mesh, copper, conductive polymer, indium tin oxide and the like are mainly used for the electrode of the touch-type button, and characteristics of button illumination of a vehicle are influenced by transmissivity of light-transmitting plastic material. Here, the higher brightness is and the more uniform a brightness distribution is, the better the quality of illumination is.

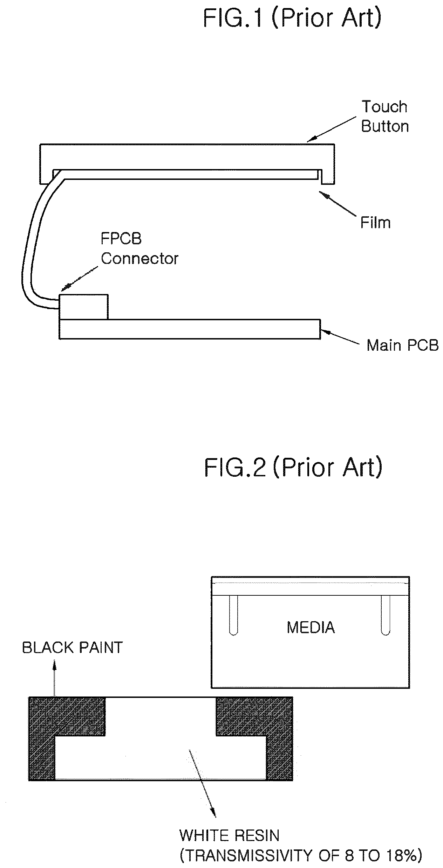

Referring to FIG. 1, in a touch-type button according to a related art, in order for light of a LED located under a touch film to come out of the touch-type button, a touch film should have a shape in which a central portion thereof is pierced, so that the button has a shape of a button cover as shown in FIG. 2.

In other words, black paint is applied on a surface of white resin formed by injection-molding polycarbonate to which white coloring agent is added, a surface portion of the white resin corresponding to a letter font is then laser-cut to manufacture a button cover, and a touch panel is formed on a rear surface of the button cover.

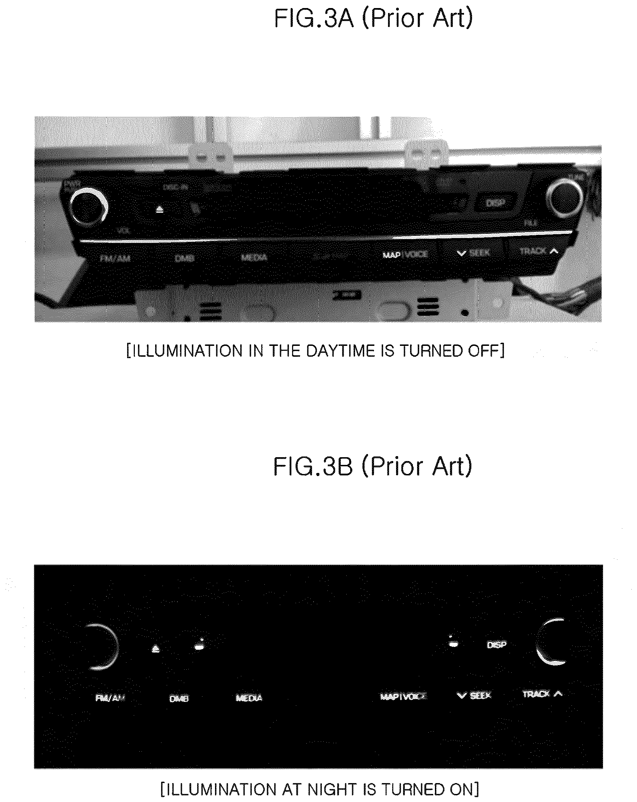

Therefore, according to this conventional method, when illumination is turned off in the daytime, a white colored switch font letter is visible as shown in FIG. 3A, and the illumination is turned on only at night as shown in FIG. 3B.

However, in the above-described conventional method, although the font is clearly visible in white by the white coloring agent in the daytime, the LED light is blocked by the coloring agent, whereby transmissivity is reduced.

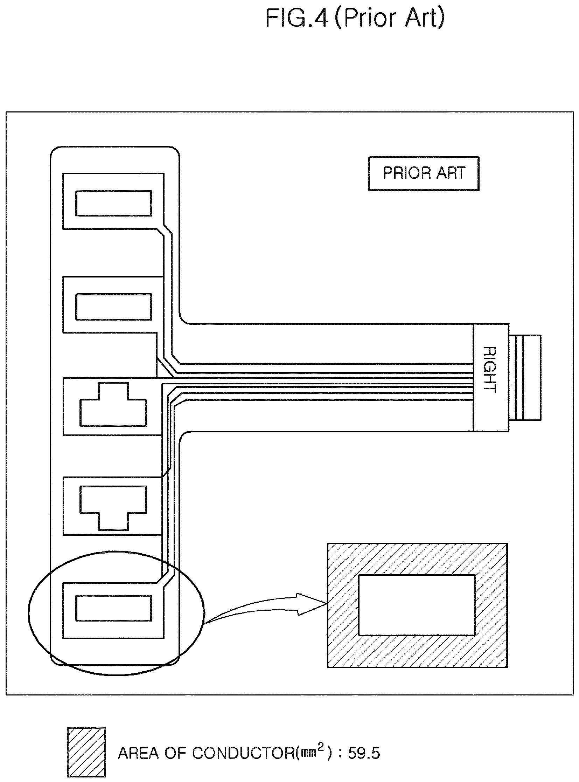

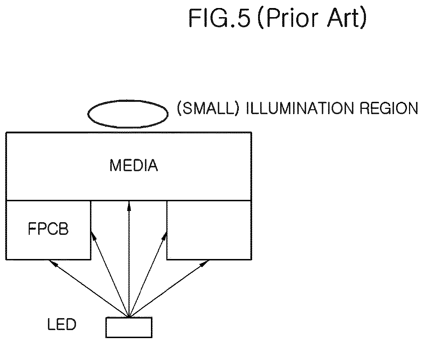

In addition, as shown in FIGS. 4 and 5, a portion where a center hole is formed becomes a region through which the LED light is transmitted, and a region surrounding the center hole is the region where a touch electrode formed of copper is formed. Therefore, an area of the conductor is reduced due to the hole, so that there is a limitation in that touch sensitivity is inevitably weak.

In addition, because the LED light comes out through a portion on which the hole is formed, an illumination region is limited.

In the letters used in the vehicle, that is, the letters such as "A/C" has a short font, but when the letters such as "TRACK" has a long font, it is difficult to form a large hole, so that there is a problem that the illumination region becomes smaller. If the illumination region becomes small as described above, uniformity of illumination on the font is deteriorated, and thus a restriction in terms of design such a size of the font and the like is also accompanied.

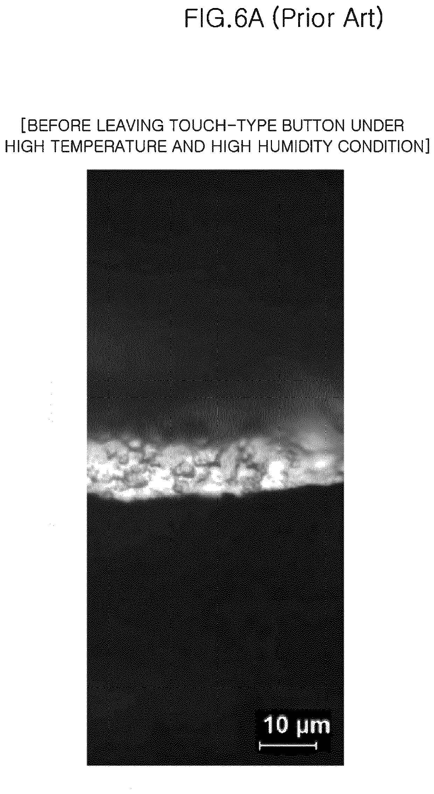

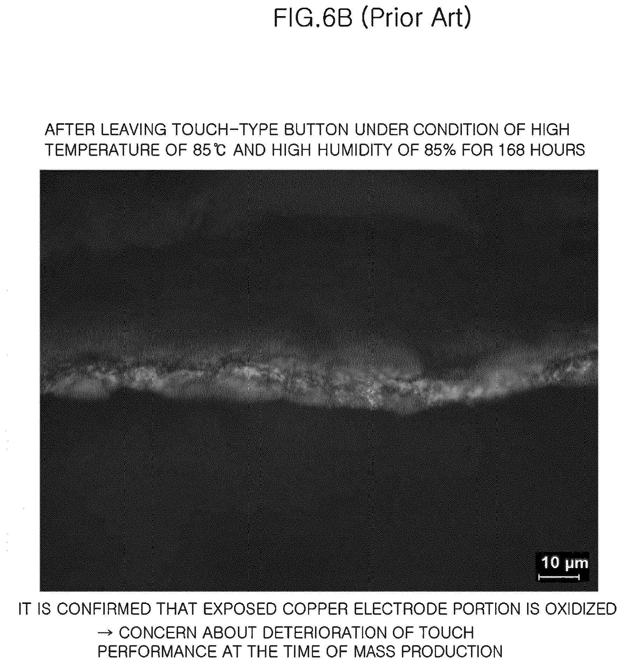

Furthermore, as can be seen from FIGS. 6A and 6B, since the hole is formed, when the touch-type button is left under a high temperature and high humidity condition for 168 hours, corrosion occurs in a section portion on which copper is exposed, which causes deterioration of a touch signal and quality problem.

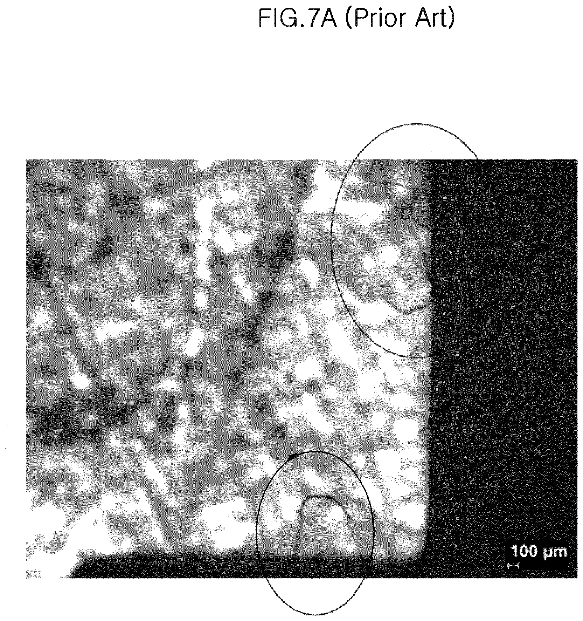

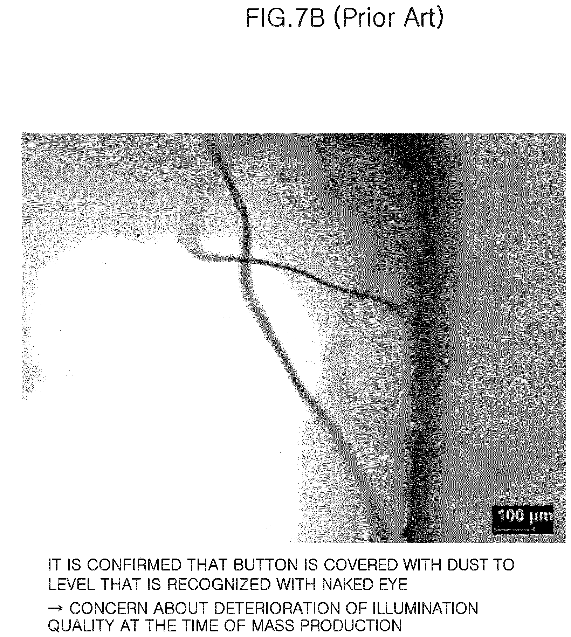

In addition, as can be seen from FIG. 7A and FIG. 7B which is an enlarged view of FIG. 7A, since a flexible printed circuit board (FPCB) is configured by stacking a plurality of components using an adhesive, when the hole is formed on the center portion, foreign substances such as dust and the like are attached to a section portion of layer on which the adhesive is existed. This can cause quality degradation of the LED backlight illumination.

The contents described in Description of Related Art are to help the understanding of the background of the present disclosure and may include what is not previously known to those skilled in the art to which the present disclosure pertains.

As relevant backgrounds, EP 3 219 534 A1 provides a user interface apparatus for vehicles including light sources, a touch sensor to sense touch, light guides to transfer light generated by the light sources, and a top cover to cover the light sources, the touch sensor and the light guides and to transmit light emitted from the light guides to the interior of a vehicle. Also, EP 2 960 916 A1 provides a display device including a display panel having an illumination portion and a non-illumination portion and an illumination member, disposed adjacent to a rear surface of the display panel, for illuminating the illumination portion. Also, JP 2008 053050 A provides an operation panel in which an identification mark is made not conspicuous.

### SUMMARY OF THE DISCLOSURE

The present disclosure has been made to solve the above-described problems, and the object of the present disclosure is to provide a touch-type button for a vehicle which can recognize a letter, day and night, using illumination, enlarge and uniformize an illumination region.

A touch-type button for a vehicle according to the present invention may include, as defined by independent claim 1: a cover defining an external appearance of the touch-type button and having a portion corresponding to a letter font; and a transparent electrode attached to a rear surface of the cover and configured to generate a signal in response to a change in capacitance. Here, the transparent electrode is configured to transmit light emitted from a light source disposed behind thereof to allow the letter font to be revealed and recognized. The cover comprises: a black film in which the portion corresponding to the letter font is cut; and a smoky resin injection molded product attached to the black film and containing a polycarbonate base to which a black coloring agent and a light diffusing additive are injection-molded integrally, wherein the black film is attached to the smoky resin in an in-mold label, IML.

According to the present invention, the cover has a thickness of 1 to 3 mm.

According to the present invention, the cover has transmissivity of 30 to 45%.

According to the present invention, the cover has turbidity of 90% or more.

The cover may have brightness (L*) of illumination from the light source that is less than 70.

According to the present invention, the transparent electrode has a thickness of less than 150 *µ*m.

According to the present invention, the transparent electrode has transmissivity of 85% or more.

The transparent electrode may have turbidity of less than 2%.

The transparent electrode may have yellowness (b*) of less than 2.

According to the present invention, the transparent electrode has a surface resistance of less than 200 Ω.

The touch-type may further include a light diffusing film attached to the transparent electrode, and the light diffusing film may have transmissivity of 85% or more and turbidity of 90% or more.

### BRIEF DESCRIPTION OF THE DRAWINGS

FIGS. 1, 2, 3A, 3B, 4, 5, 6A, 6B, 7A, and 7B are diagrams showing a method of manufacturing a conventional button for a vehicle and a problem thereof.
FIG. 8 is a diagram showing an operating method of a touch-type button for a vehicle according to an exemplary embodiment of the present disclosure.
FIGS. 9A and 9B are diagrams illustrating the results of the touch-type button for the vehicle according to an exemplary embodiment of the present disclosure which is implemented by the method shown in FIG. 8.
FIG. 10 is a diagram schematically illustrating the touch-type button for the vehicle according to an exemplary embodiment of the present disclosure.
FIGS. 11 and 12 are diagrams illustrating one configuration of the touch-type button for the vehicle according to an exemplary embodiment of the present disclosure.
FIG. 13 is a diagram illustrating a method of evaluating the touch-type button for the vehicle according to an exemplary embodiment of the present disclosure.
FIG. 14 is a diagram showing a composition of a hidden cover of the touch-type button for the vehicle according to an exemplary embodiment of the present disclosure.
FIGS. 15A to 15D are diagrams showing embodiments according to transmissivities of the touch-type button for the vehicle according to an exemplary embodiment of the present disclosure.
FIGS. 16A and 16B are diagrams for comparing differences in illumination according to applications of a touch film.
FIG. 17 is a diagram schematically illustrating a touch-type button for a vehicle in accordance with another exemplary embodiment of the present disclosure.

### DESCRIPTION OF SPECIFIC EMBODIMENTS

In order to fully understand the present disclosure, operational advantages of the present disclosure and objects achieved by implementing embodiments of the present disclosure, reference should be made to the accompanying drawings illustrating exemplary embodiments of the present disclosure and the description on the accompanying drawings.

In describing exemplary embodiments of the present disclosure, a description on well-known technologies or a repetitive description which may unnecessarily obscure the gist of the present disclosure will be abbreviated or omitted.

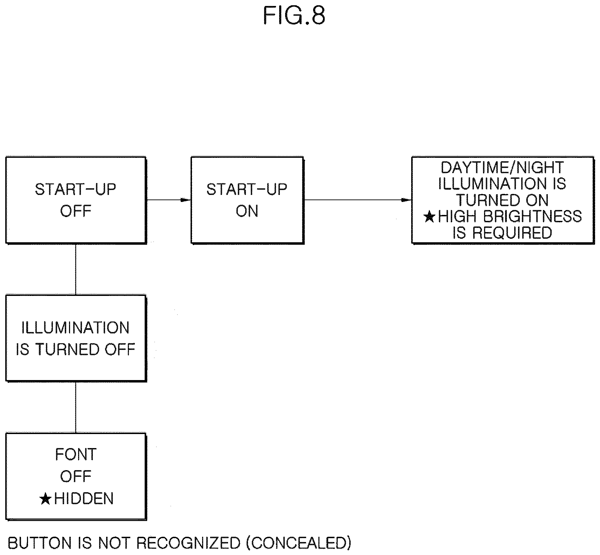

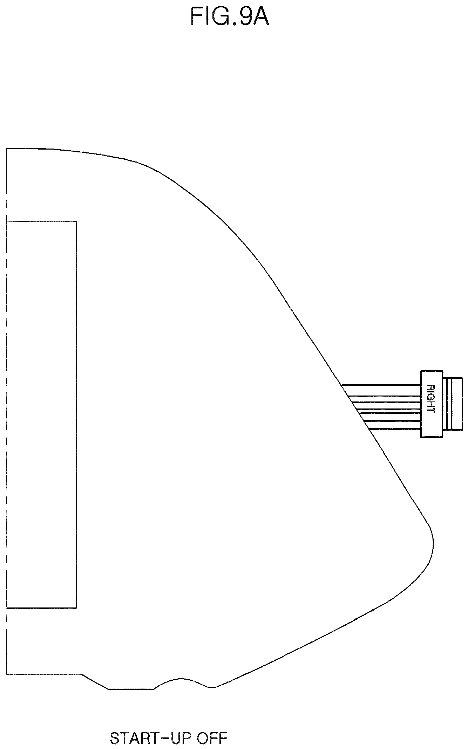

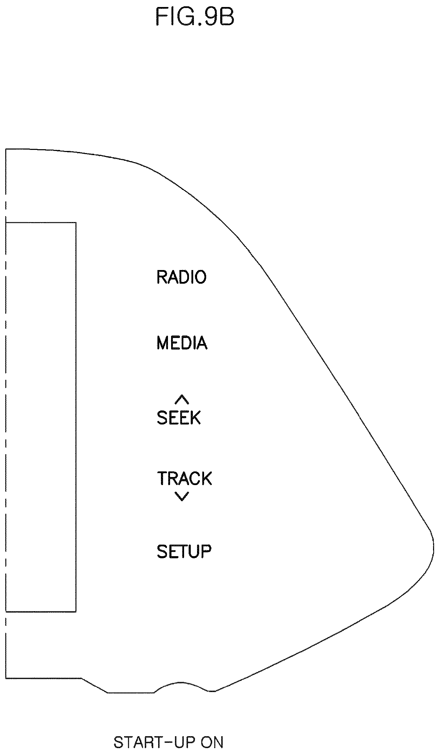

FIG. 8 is a diagram showing an operating method of a touch-type button for a vehicle according to an exemplary embodiment of the present disclosure, and FIGS. 9A and 9B are diagrams illustrating the result of the touch-type button for the vehicle according to an exemplary embodiment of the present disclosure which is implemented by the method shown in FIG. 8.

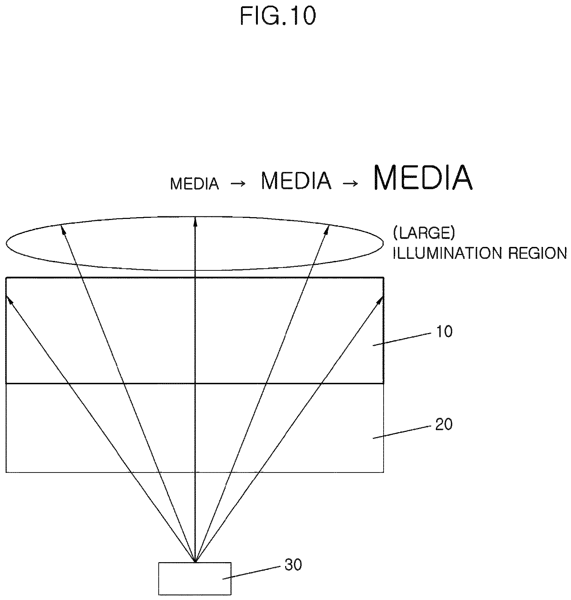

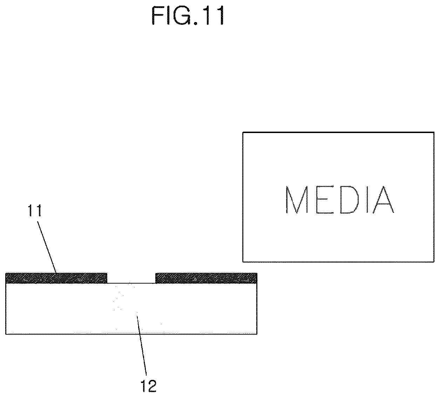

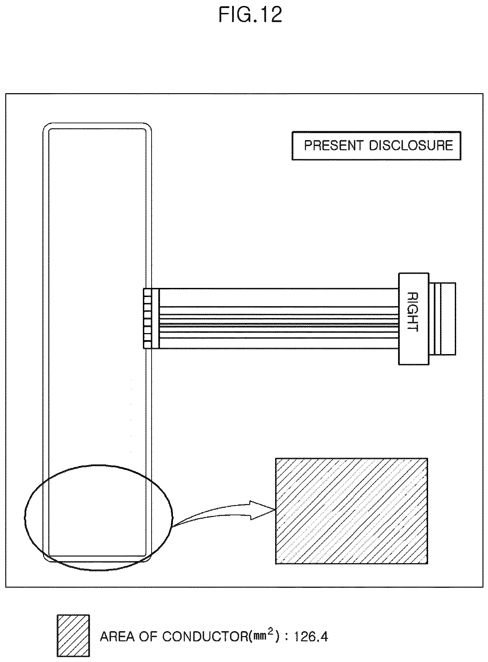

In addition, FIG. 10 is a diagram schematically illustrating the touch-type button for the vehicle according to an exemplary embodiment of the present disclosure, and FIGS. 11 and 12 are diagrams illustrating one configuration of the touch-type button for the vehicle according to an exemplary embodiment of the present disclosure.

Below, the touch-type button for the vehicle according to one exemplary embodiment of the present disclosure is described with reference to FIGS. 8, 9A, 9B, 10, 11, and 12.

A conventional touch-type button for a vehicle adopts a simple method in which a font of button is appeared in white in the daytime and illumination is turned on only at night. According to the above, brightness of the night illumination should be thus low, because glare and light blur occur when illumination is bright. Therefore, the conventional touch-type button does not require high brightness.

On the contrary, in the present disclosure, a hidden function by which a font of letter is not visible as shown in FIG. 9A is realized in a state in which a vehicle has not started and illumination is turned off as shown in FIG. 8, and when the vehicle starts, the illumination is turned-on day and night as shown in FIG. 9B to allow the font of letter to be revealed by the illumination, and high brightness is thus needed.

As illustrated in FIG. 10, to this end, the touch-type button for the vehicle according to an exemplary embodiment of the present disclosure includes a hidden cover 10 and a transparent electrode, for example, an indium tin oxide (ITO) touch film 20. In addition, a transparent adhesive such as an optical clear adhesive (OCA) may be interposed between the hidden cover 10 and the ITO touch film.

The hidden cover 10 corresponds to an external appearance of the button which is exposed to the outside and allows a user to touch the hidden cover, and the transparent electrode is attached to a rear surface of the hidden cover 10, so that the amount of change in capacitance is transmitted through a printed circuit board (PCB) (not shown) connected to the transparent electrode, and a touch input is thus recognized.

The hidden cover 10 and the transparent electrode transmit light emitted from a light emitting diode (LED) 30, so that letter fonts patterned on the hidden cover 10 are brighter than surroundings thereof to enable the user to recognize the letter fonts.

Referring to FIG. 11, the hidden cover 10 is composed of an in-mold label (IML) film 11 and a smoky resin injection molded product 12.

The hidden cover 10 is manufactured by laser-cutting a black film in accordance with the letter fonts and then attaching the black film to the smoky resin injection molded product, which is a composition of polycarbonate (PC), black coloring agent and light diffusing additive, in an in-mold label (IML) process.

By configuring the hidden cover as above, the letter font is not exposed in the absence of illumination, and the illuminated region can be widened due to the high light transmittance of the transparent electrode. In addition, a conductor area is increased as shown in FIG. 12, and touch sensitivity can be thus enhanced more than twice.

The conditions of the hidden cover 10 and the transparent electrode of the present disclosure described above are summarized in Table 1, and the ITO touch film 20 was employed as an example of the transparent electrode.

**Table 1**

| Hidden cover | | | | ITO touch film | | | | |
|---|---|---|---|---|---|---|---|---|
| Thickne ss (mm) | Transmissi vity (%) | Turbidit y (%) | Brightn ess (L*) | Thickne ss (µm) | Transmissi vity (%) | Turbid ity (%) | Yellow ness (b*) | Sheet resista nce (Ω) |
| 1~3 | 30~45 | 90 or more | Less than 70 | Less than 150 | 85 or more | Less than 2 | Less than 2 | Less than 200 |

First of all, a thickness of the hidden cover 10 may be 1 to 3mm.

When the thickness of the hidden cover 10 is out of the above range and is less than 1 mm, flexure of the hidden may be occurred after performing an environmental durability test, and when the thickness of the hidden cover exceeds 3 mm, a distance between the electrode and the user's finger is increased, and so the touch performance may be degraded.

In addition, within this thickness range, the hidden cover should have transmissivity of 30 to 45%.

When transmissivity of the hidden cover 10 is less than 30%, the light transmittance of the LED is deteriorated, and brightness performance of the illumination is thus degraded. In addition, if the transmissivity exceeds 45%, even when the lighting is turned off, the font is recognized with the naked eye and a hidden characteristic is thus degraded, and a hot spot phenomenon, in which the illumination is brightly looked as a point light source due to a straight advancing property of the LED illumination, occurs to lower uniformity of the illumination.

Brightness can be determined according to the transmittance, and when the brightness L* exceeds 70, the font is also recognized with the naked eye and the hidden characteristic is thus degraded.

In addition, the LED light is not diffused well in a condition of turbidity of less than 90%, and therefore, there is a problem that uniformity of the illumination is deteriorated.

Next, the total thickness of the ITO touch film 20 should not exceed 150 µm.

If the total thickness exceeds 150 µm, durability of the ITO touch film may be degraded due to bending. In addition, transmissivity of the ITO touch film should be 85 % or more in accordance with Japanese Industrial Standard (JIS)-K-7361 which is the internal standard, and turbidity should be less than 2% in accordance with JIS-K-7136.

When the transmissivity is less than 85%, light loss of the LED light is increased, and so brightness of the illumination may be deteriorated. If the turbidity is 2% or more, the brightness of the illumination may be deteriorated due to light scattering of the LED light.

Yellowness b* should be less than 2 in accordance with JIS-Z-8722 (Methods of colour measurement - Reflecting and transmitting objects).

If the yellowness is 2 or more, a color coordinate of the LED illumination color may be shifted due to yellowing of the film and the illumination color may be thus changed.

In addition, when surface resistance is 200 Ω or more, touch performance may be degraded and it is thus desirable that surface resistance is less than 200 Ω.

In the case where the thickness, the brightness, the turbidity, the transmissivity of the hidden cover, and the thickness, the transmissivity, the turbidity, the yellowness and the surface resistance of the ITO touch film satisfy the above-mentioned conditions, a hidden function is realized when the illumination is turned off, and the light may be bright and uniform when the illumination is turned on and performance desired by the present disclosure can be achieved.

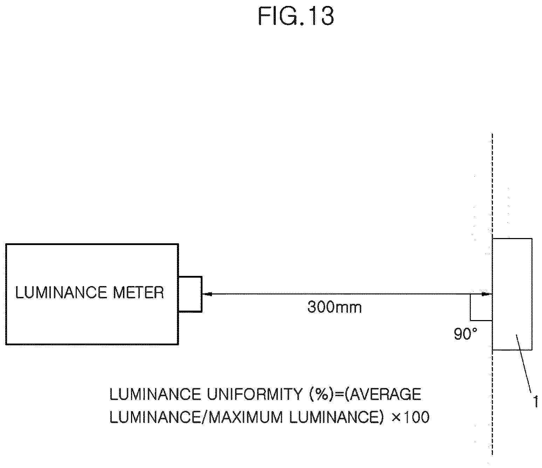

FIG. 13 schematically illustrates a method of evaluating the illumination emitted through the touch-type button for the vehicle according to an exemplary embodiment of the present disclosure using a two-dimensional imaging type luminance measuring instrument, and the light uniformity of illumination should be 60% or more.

In addition, the brightness at the button 1 which is 30 cm away from a lens of the measuring instrument should be more than 400cd/m² so that the touch-type button can be used in the daytime.

The present disclosure includes the hidden cover 10 and the ITO touch film 20 having the above-described conditions, thereby functioning as a button configured to transmit a touch input signal to a controller (not shown) through a user's operation.

In other words, the hidden cover 10 is a plastic insulator, and the touch film 20 made of ITO acts as an electrode. Basically, when a human's hand touches the electrode in a state where the electrode has constant capacitance, a touch signal is sensed by a change in capacitance.

Since as compared to a conventional flexible printed circuit board (FPCB), ITO has a large electrode area, ITO has a large capacitance and excellent touch sensitivity.

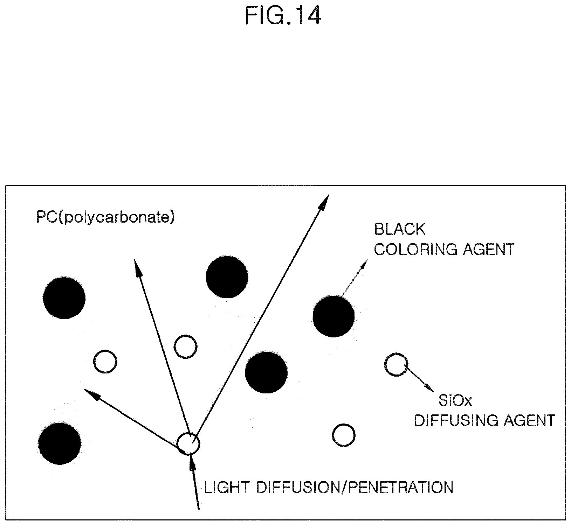

In addition, the hidden cover 10 is provided for preventing the font from being revealed in the absence of illumination, and as shown in FIG. 14, PC, which is base material of the hidden cover, contains black coloring agent and silicon dioxide (SiOₓ) light diffusing agent as an additive. The transmissivity of the hidden cover can be adjusted by adjusting the content of black coloring agent. This is because the black coloring agent prevents the light of the LED from being transmitted.

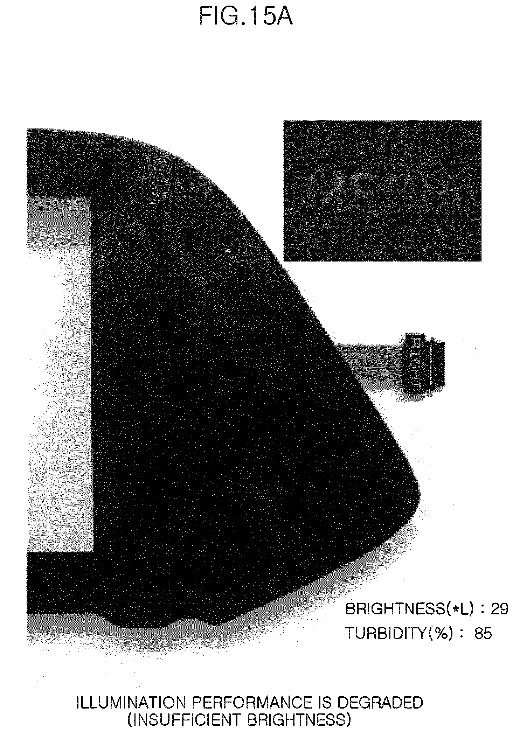

Thus, as shown in FIGS. 15A to 15D, the hidden characteristic may be realized in a proper transmissivity range of the hidden cover. In FIGS. 15A to 15D, a part shown on a background indicates a state in which the illumination is turned off, and another part shown on an upper right corner indicates a state in which the illumination is turned on.

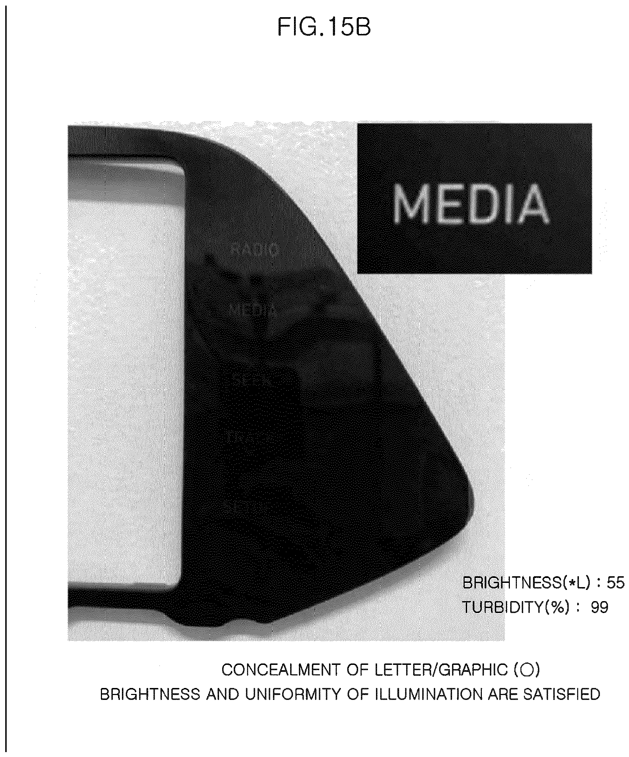

In other words, FIG. 15A shows a case where the transmissivity is 8%, and it can be seen that the illumination performance is degraded (insufficient brightness). In addition, FIG. 15B shows a case where the transmissivity is 30% corresponding to the present disclosure, and it can be seen that a letter or a graphic is concealed and that the brightness and uniformity of illumination are satisfied.

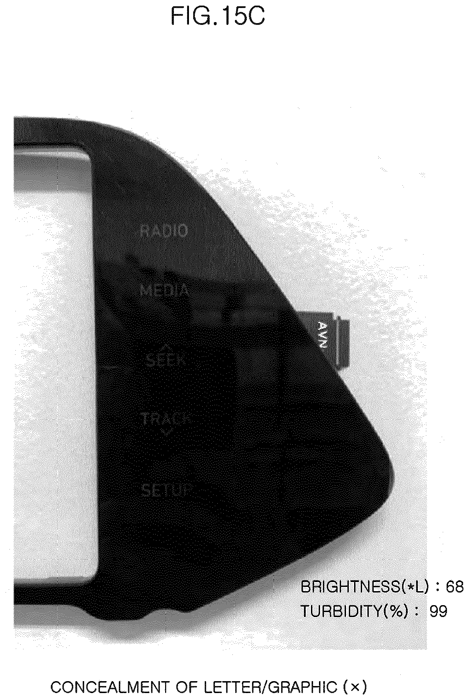

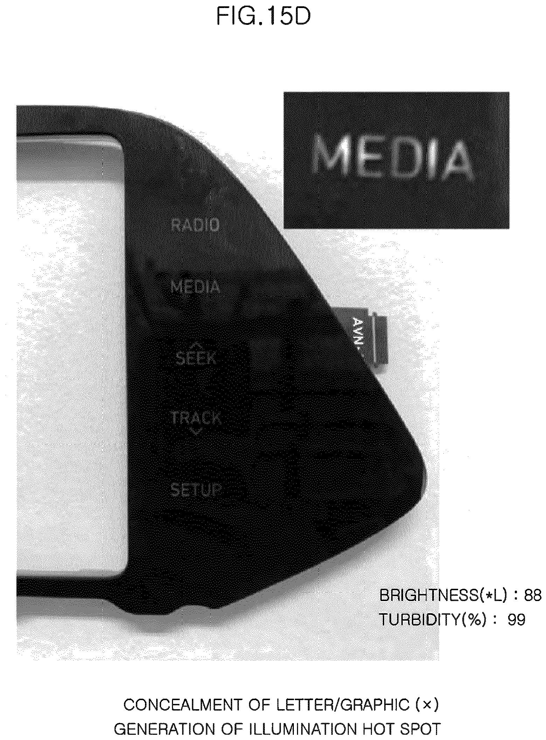

In addition, FIG. 15C shows a case where the transmissivity is 51%, and it can be seen that the letter and the graphic are not concealed. FIG. 15D shows a case where the transmissivity is 73%, and it can be seen that the letter and the graphic are not concealed and a hot spot occurs in the illumination.

In addition, since the light of the LED has the straight advancing property, the light diffusing agent is added. By adjusting an addition of the light diffusing agent, the optimum transmissivity range, turbidity range and brightness value of the hidden cover were derived.

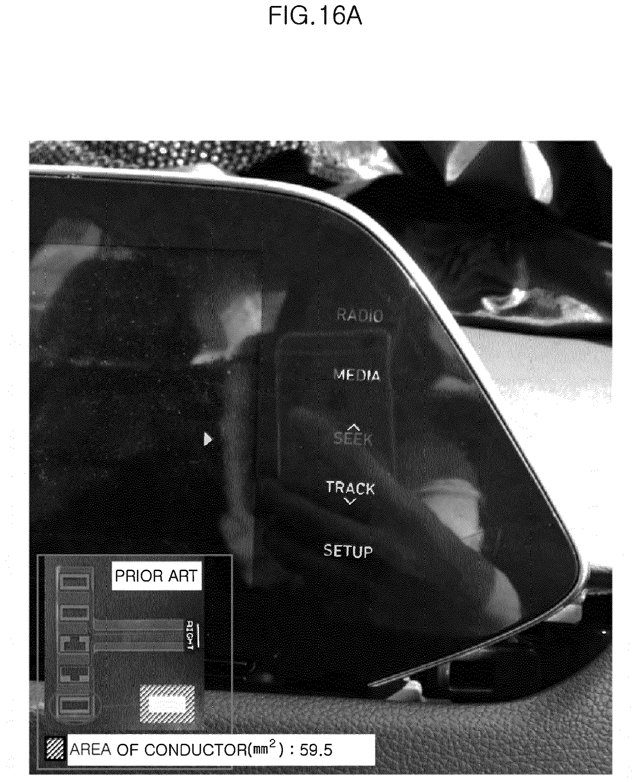

Even when the same hidden cover is applied, a characteristic of illumination is varied depending on the type of the touch film. FIG. 16A shows a case in which a conventional FPCB type touch switch is used, an uneven phenomenon of the illumination occurs due to the LED light going straight through a perforated hole.

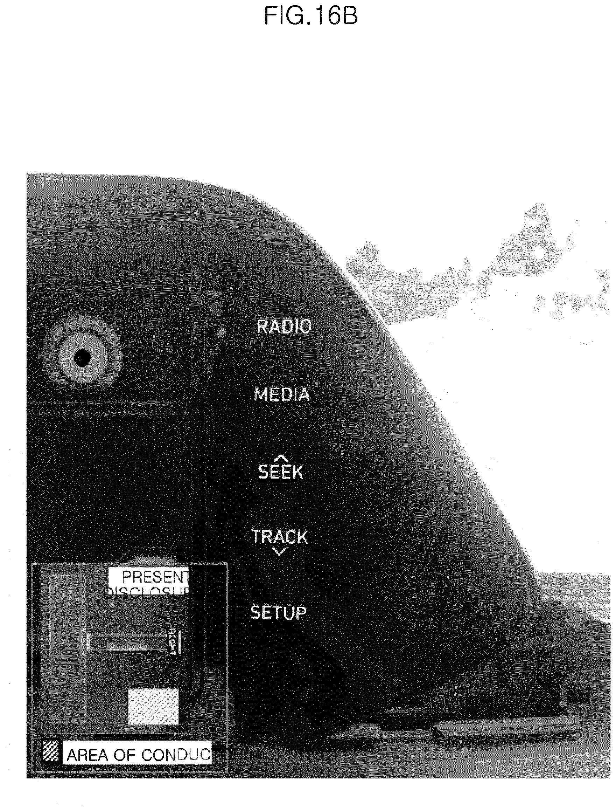

On the contrary, in the case where the ITO touch film of the present disclosure is employed as shown in FIG. 16B, while the light passes through a transparent wide area of ITO, diffusion/scattering of the light through the film occurs, and the uniformity of illumination is thus improved by the light diffusion effect caused by the above.

The characteristics derived from the experimental results according to characteristic ranges of the hidden cover and the electrode of the present disclosure are summarized in the following tables together with comparative examples. Table 2 shows Example and Comparative examples, and Table 3 shows experimental results.

**Table 2**

| | Cover | | | | | Electrode | | | | | | |
|---|---|---|---|---|---|---|---|---|---|---|---|---|
| | Materia l | A (mm ) | B | C | D | Materia l | A (µm ) | B | C | E | F | G |
| Comparati ve Example 1 | White resin | 1.5 | 40 | 99 | 55 | ITO | 150 | 89 | 0.4 3 | 1.7 | 150 | O |
| Comparati ve Example 2 | White resin | 1.5 | 40 | 99 | 55 | FPCB | 150 | - | - | - | - | O |
| Example 1 | Smoky resin | 1.5 | 40 | 99 | 55 | ITO | 150 | 89 | 0.4 2 | 1.7 | 150 | O |
| Comparati ve Example 3 | Smoky resin | 0.5 | 53 | 99 | 55 | ITO | 150 | 89 | 0.4 2 | 1.7 | 150 | O |
| Comparati ve | Smoky resin | 4 | 40 | 99 | 55 | ITO | 150 | 89 | 0.4 | 1.7 | 150 | O |
| Example 4 | | | | | | | | | 2 | | | |
| Comparati ve Example 5 | Smoky resin | 1.5 | 20 | 99 | 55 | ITO | 150 | 89 | 0.4 2 | 1.7 | 150 | O |
| Comparati ve Example 6 | Smoky resin | 1.5 | 50 | 99 | 55 | ITO | 150 | 89 | 0.4 2 | 1.7 | 150 | O |
| Comparati ve Example 7 | Smoky resin | 1.5 | 43 | 80 | 55 | ITO | 150 | 89 | 0.4 2 | 1.7 | 150 | O |
| Comparati ve Example 8 | Smoky resin | 1.5 | 30 | 99 | 88 | ITO | 150 | 89 | 0.4 2 | 1.7 | 150 | O |
| Comparati ve Example 9 | Smoky resin | 1.5 | 40 | 99 | 55 | FPCB | 150 | 89 | 0.4 2 | 1.7 | 150 | O |
| Comparati ve Example 10 | Smoky resin | 1.5 | 40 | 99 | 55 | ITO | 200 | 89 | 0.4 2 | 1.7 | 150 | X |
| Comparati ve Example 11 | Smoky resin | 1.5 | 40 | 99 | 55 | ITO | 150 | 80 | 0.4 2 | 1.7 | 150 | O |
| Comparati ve Example 12 | Smoky resin | 1.5 | 40 | 99 | 55 | ITO | 150 | 86 | 3 | 1.7 | 150 | O |
| Comparati ve Example 13 | Smoky resin | 1.5 | 40 | 99 | 55 | ITO | 150 | 89 | 0.4 2 | 3.6 | 150 | O |
| Comparati ve Example 14 | Smoky resin | 1.5 | 40 | 99 | 55 | ITO | 150 | 89 | 0.4 2 | 1.7 | 250 | O |

Here, in Table 2, A indicates Thickness (mm), B indicates Transmissivity (%), C indicates Turbidity (%), D indicates Brightness (L*), E indicates Yellowness (b*), F indicates Sheet resistance (Ω), and G indicates whether flexibility is satisfied.

**Table 3**

| | Luminanc e (Cd/m²) | Uniformit y (%) | Whether change in color of illumination is satisfied | Whether touch reaction is satisfied | Whether font is hidden |
|---|---|---|---|---|---|
| Comparative example 1 | 2 | 58 | O | O | X |
| Comparative example 2 | 2.5 | 51 | O | O | X |
| Example 1 | 417 | 70 | O | O | O |
| Comparative example 2 | 451 | 43 | O | O | X |
| Comparative example 4 | 233 | 71 | O | O | O |
| Comparative example 5 | 348 | 73 | O | O | O |
| Comparative example 6 | 564 | 53 | O | O | X |
| Comparative example 7 | 449 | 58 | O | O | O |
| Comparative example 8 | 387 | 71 | O | O | X |
| Comparative example 9 | 374 | 46 | O | O | O |
| Comparative example 10 | 391 | 71 | O | O | O |
| Comparative example 11 | 350 | 70 | O | O | O |
| Comparative example 12 | 390 | 72 | O | O | O |
| Comparative example 13 | 411 | 70 | X | O | O |
| Comparative example 14 | 413 | 71 | O | X | O |

As summarized in the above tables, in the case of Comparative examples 1 and 2, it can be seen that the font is recognized with the naked eye by white coloring agent in the daytime, so that it is impossible to realize the hidden function.

Even when the cover is made of smoky resin, if the cover is thin as in Comparative example 3, the transmissivity is also increased and the light of the LED having the strong straight advancing property is not diffused well in the resin, resulting in the illumination in the form of spot. As a result, the uniformity of illumination is deteriorated.

On the contrary, as in the case of Comparative example 4, when the thickness of the cover is increased by a predetermined value or more, the transmissivity is decreased, and so luminance of the illumination is lowered.

In addition, as can be seen from Comparative examples 5 and 6, when the transmissivity of the cover is smaller than a reference value, luminance of the illumination is lowered. On the contrary, when the transmissivity of the cover is higher than the reference value, the luminance of the illumination is improved, but the uniformity of illumination is deteriorated.

Further, as in Comparative example 7, when turbidity of the cover is smaller than a certain value, the uniformity of illumination is deteriorated, and when brightness of the cover is higher than a certain value as in Comparative example 8, it is difficult to realize a hidden function to a level at which the font is recognized with the naked eye, and the transmissivity is somewhat decreased due to an addition of white coloring agent, so that the luminance of illumination is deteriorated.

Next, when a material of the electrode is FPCB, as in Comparative example 9, there is a problem that the luminance is insufficient and the uniformity is deteriorated even if the electrode is formed of smoky resin and has the optimum structure.

In addition, when a thickness of the electrode is greater than a predetermined value, as in Comparative example 10, when an evaluation of bending ability of the film on which ITO is deposited is conducted, surface resistance is generated due to fine cracks of ITO. Therefore, the touch performance is degraded.

In the case of Comparative example 11, the transmissivity of the electrode is lowered to a certain value, so that the transmittance of the light of the LED is deteriorated and the luminance of the illumination is reduced. In the case of Comparative example 12, the turbidity of the electrode is increased to a certain value or more, a decrease in the luminance of illumination is generated.

In addition, when yellowness of the electrode is high as in Comparative example 13, light characteristic such as absorption of light is changed when the LED illumination is transmitted, so that the illumination color is changed. When surface resistance of the electrode is higher than a certain value or more, touch performance is degraded due to a decrease in capacitance.

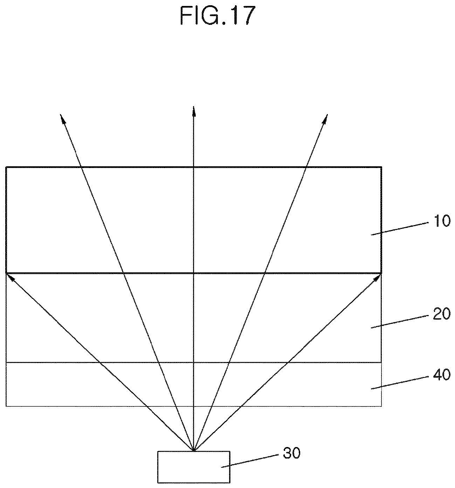

FIG. 17 schematically illustrates a touch-type button for a vehicle according to another exemplary embodiment of the present disclosure.

As shown in FIG. 17, in another embodiment of the present disclosure, optical characteristics can be further improved by adding a light diffusing film 40. The light diffusing film 40 attached to the ITO touch film 20 may have transmissivity of 85% or more and haze (turbidity) of 90% or more.

That is, when the transmissivity is smaller than the above range, the brightness of the LED illumination is deteriorated, and when the haze is smaller than the above range, the light uniformity is deteriorated due to lowered light diffusivity.

A conventional touch-type button has been configured to be operated in a manner in which the font of the button is appeared in white in the daytime and the lighting is turned on only at night. Consequently, when night illumination is too bright, glare and light blur occur, so that brightness of the night illumination has to be low.

However, according to the touch-type button for a vehicle of the present disclosure, a hidden function by which the font is not visible before a vehicle is started-up is realized, and the font is illuminated by the illumination at the moment of starting-up the vehicle. Therefore, it is possible to recognize the font, day and night, using the illumination, and to obtain high brightness performance.

In addition, since the ITO touch film employed as the transparent electrode is directly attached to the rear surface of the hidden cover, the illumination area can be widened through the high light transmittance, and by realizing the uniform illumination, size of the font can be variously made.

In addition, there is an advantage that since the conductor area is increased, the touch sensitivity is improved more than twice.

Although the present disclosure has been described with reference to the exemplary drawings, the present disclosure is not limited to the described embodiments, and it will be apparent to those skilled in the art that the present disclosure may be variously modified and changed without departing from the scope of the present disclosure. Accordingly, the scope of the invention is defined in the appended independent claim, and preferred embodiments are defined in the appended dependent

## Claims

1. A touch-type button for a vehicle, comprising:
a cover (10) defining an external appearance of the touch-type button and having a portion corresponding to a letter font; and
a transparent electrode attached to a rear surface of the cover and configured to generate a signal in response to a change in capacitance,
wherein the transparent electrode is configured to transmit light emitted from a light source (30) disposed behind the transparent electrode to allow the letter font to be revealed and recognized,
wherein the cover (10) comprises:
a black film in which the portion corresponding to the letter font is cut; and
a smoky resin injection molded product attached to the black film and containing a polycarbonate base to which a black coloring agent and a light diffusing additive are injection-molded integrally;
**characterised in that**
the black film is attached to the smoky resin in an in-mold label, IML,
wherein transmissivity of light transmitted through the cover is 30 to 45% of light emitted from the light source,
wherein the cover has turbidity of 90% or more,
wherein transmissivity of light transmitted through the transparent electrode is 85% or more of light emitted from the light source,
wherein the cover has a thickness of 1 to 3 mm,
wherein the transparent electrode has a thickness of less than 150 *µ*m,
wherein the transparent electrode has a surface resistance of less than 200 Ω.

2. The touch-type button of claim 1, wherein the cover has brightness L* of illumination from the light source (30) that is less than 70.

3. The touch-type button of claim 1, wherein the transparent electrode has turbidity of less than 2%.

4. The touch-type button of claim 1, wherein the transparent electrode has yellowness b* of less than 2.

5. The touch-type button of claim 1, further comprising a light diffusing film attached to the transparent electrode.

6. The touch-type button of claim 5, wherein the light diffusing film has transmissivity of 85% or more and turbidity of 90% or more.

## Patentansprüche

1. Taste vom Berührungstyp für ein Fahrzeug, umfassend:
eine Abdeckung (10), die das äußere Erscheinungsbild der Taste vom Berührungstyp definiert und einen Abschnitt aufweist, der einer Buchstabenschrift entspricht; und
eine transparente Elektrode, die an einer hinteren Fläche der Abdeckung angebracht und eingerichtet ist, um ein Signal als Reaktion auf eine Kapazitätsänderung zu erzeugen,
wobei die transparente Elektrode eingerichtet ist, um Licht zu übertragen, das von einer Lichtquelle (30) emittiert wird, die hinter der transparenten Elektrode angeordnet ist, um zu ermöglichen, dass die Buchstabenschrift sichtbar und erkennbar wird,
wobei die Abdeckung (10) umfasst:
eine schwarze Folie, in die der Abschnitt, der der Buchstabenschrift entspricht, geschnitten ist; und
ein Rauchharz-Spritzgusserzeugnis, das an der schwarzen Folie angebracht ist und eine Polycarbonatbasis enthält, in die ein schwarzer Farbstoff und ein lichtstreuender Zusatzstoff einstückig spritzgegossen sind,
**dadurch gekennzeichnet, dass**
die schwarze Folie in einem In-Mold-Label, IML, an dem Rauchharz angebracht ist,
wobei die Durchlässigkeit des Lichts, das durch die Abdeckung dringt, 30 bis 45 % des Lichts beträgt, das von der Lichtquelle emittiert wird,
wobei die Abdeckung eine Trübung von 90 % oder mehr aufweist,
wobei die Durchlässigkeit des Lichts, das durch die transparente Elektrode dringt, 85 % oder mehr des Lichts beträgt, das von der Lichtquelle emittiert wird,
wobei die Abdeckung eine Dicke von 1 bis 3 mm aufweist,
wobei die transparente Elektrode eine Dicke von weniger als 150 µm aufweist,
wobei die transparente Elektrode einen Flächenwiderstand von weniger als 200 Ω aufweist.

2. Taste vom Berührungstyp nach Anspruch 1, wobei die Abdeckung eine Helligkeit L* der Beleuchtung von der Lichtquelle (30) aufweist, die kleiner als 70 ist.

3. Taste vom Berührungstyp nach Anspruch 1, wobei die transparente Elektrode eine Trübung von weniger als 2 % aufweist.

4. Taste vom Berührungstyp nach Anspruch 1, wobei die transparente Elektrode einen Gelbwert b* von weniger als 2 aufweist.

5. Taste vom Berührungstyp nach Anspruch 1, ferner umfassend eine lichtstreuende Folie, die an der transparenten Elektrode angebracht ist.

6. Taste vom Berührungstyp nach Anspruch 5, wobei die lichtstreuende Folie eine Durchlässigkeit von 85 % oder mehr und eine Trübung von 90 % oder mehr aufweist.

## Revendications

1. Bouton de type tactile pour un véhicule, comprenant :
un couvercle (10) définissant une apparence externe du bouton de type tactile et présentant une partie correspondant à une police de caractère ; et
une électrode transparente fixée à une surface arrière du couvercle et conçue pour générer un signal en réponse à un changement de capacité,
l'électrode transparente étant conçue pour transmettre de la lumière émise par une source de lumière (30) disposée derrière l'électrode transparente afin de permettre à la police de caractère d'apparaître et d'être reconnue,
le couvercle (10) comprenant :
un film noir dans lequel la partie correspondant à la police de caractère est coupée ; et
un produit moulé par injection de résine couleur fumée fixé au film noir et contenant une base de polycarbonate sur laquelle un agent colorant noir et un additif diffusant la lumière sont moulés par injection d'un seul tenant,
**caractérisé en ce que** le film noir est fixé à la résine couleur fumée dans une étiquette surmoulée, IML (in-mold label),
dans lequel le pouvoir de transmission de la lumière transmise à travers le couvercle est de 30 à 45 % de la lumière émise par la source de lumière,
dans lequel le couvercle présente une turbidité supérieure ou égale à 90 %,
dans lequel le pouvoir de transmission de la lumière transmise à travers l'électrode transparente est supérieur ou égal à 85 % de la lumière émise par la source de lumière,
dans lequel le couvercle présente une épaisseur de 1 à 3 mm,
dans lequel l'électrode transparente présente une épaisseur inférieure à 150 µm,
dans lequel l'électrode transparente présente une résistance de surface inférieure à 200 Ω.

2. Bouton de type tactile selon la revendication 1, dans lequel le couvercle présente une luminosité L* d'éclairage provenant de la source de lumière (30) qui est inférieure à 70.

3. Bouton de type tactile selon la revendication 1, dans lequel l'électrode transparente présente une turbidité inférieure à 2 %.

4. Bouton de type tactile selon la revendication 1, dans lequel l'électrode transparente présente une teinte jaune b* inférieure à 2.

5. Bouton de type tactile selon la revendication 1, comprenant en outre un film diffusant la lumière fixé à l'électrode transparente.

6. Bouton de type tactile selon la revendication 5, dans lequel le film diffusant la lumière présente un pouvoir de transmission supérieur ou égal à 85 % et une turbidité supérieure ou égale à 90 %.
